(19) Europäisches Patentamt
European Patent Office
Office européen des brevets

(11) **EP 2 779 450 B1**

(12) **EUROPEAN PATENT SPECIFICATION**

(45) Date of publication and mention
of the grant of the patent:
**20.07.2016 Bulletin 2016/29**

(51) Int Cl.:
**H03K 3/0233** (2006.01)   **H03K 3/3565** (2006.01)

(21) Application number: **13159121.6**

(22) Date of filing: **14.03.2013**

(54) **A METHOD AND APPARATUS FOR GENERATING AN OSCILLATION SIGNAL**

VERFAHREN UND VORRICHTUNG ZUR ERZEUGUNG EINES SCHWINGUNGSSIGNALS

PROCÉDÉ ET APPAREIL DE GÉNÉRATION DE SIGNAL D'OSCILLATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**17.09.2014 Bulletin 2014/38**

(73) Proprietor: **ROHM CO., LTD.**
**Kyoto 615-8585 (JP)**

(72) Inventor: **Mladenova, Irina**
**Ukyo-ku**
**Kyoto 615-8585 (JP)**

(74) Representative: **Isarpatent**
**Patent- und Rechtsanwälte Behnisch Barth Charles**
**Hassa Peckmann & Partner mbB**
**Friedrichstrasse 31**
**80801 München (DE)**

(56) References cited:
**WO-A1-2004/088844    DE-A1- 4 033 025**
**JP-A- 2001 331 306**

- **"CMOS Schmitt Trigger - A Uniquely Versatile Design Component", , 31 December 1998 (1998-12-31), pages 1-8, XP055073901, Retrieved from the Internet: URL:http://www.fairchildsemi.com/an/AN/AN-140.pdf [retrieved on 2013-08-01]**
- **KAYA S ET AL: "A novel voltage-controlled ring oscillator based on nanoscale DG-MOSFETs", 14 December 2008 (2008-12-14), MICROELECTRONICS, 2008. ICM 2008. INTERNATIONAL CONFERENCE ON, IEEE, PISCATAWAY, NJ, USA, PAGE(S) 417 - 420, XP031615728, ISBN: 978-1-4244-2369-9 * the whole document ***

**Description**

The invention relates to a method and apparatus for the generation of an oscillation signal which can be used in a wide range of applications such as charge pumps and/or buck and boost converters.

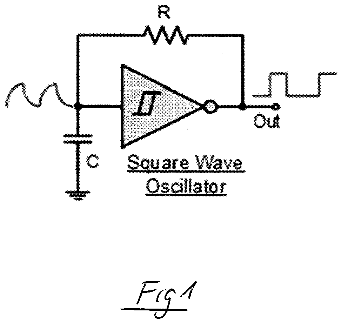

In many cases, oscillator circuits providing not absolutely exact defined oscillation frequencies can be used, for instance in charge pumps or buck and boost converters. In these applications simple oscillator circuits based on a Schmitt trigger can be used as illustrated in Fig. 1.

In "CMOS Schmitt Trigger, A Uniquely Versatile Design Component", 31. Dezember 1998 (1998-12-31), an oscillator circuit using a CMOS Schmitt trigger is described.

WO 2004/08844 A1 describes a Schmitt trigger circuit having an inverter where the potential of the bulk of a transistor of said inverter is switched by a level shifter in order to provide a hysteresis of said inverter.

Fig. 1 shows a conventional oscillator circuit based on a Schmitt trigger. A Schmitt trigger forms an active entity within the oscillator circuit and is implemented as a logical inverter having an embedded input hysteresis. The conventional oscillator circuit as shown in Fig. 1 is a square wave oscillator generating a square wave output oscillation signal with a predefined oscillation frequency. Although the conventional oscillator circuit comprising a Schmitt trigger as shown in Fig. 1 has a low complexity it also shows some disadvantages.

A disadvantage of the conventional oscillator circuit shown in Fig. 1 is that during switching high cross current peaks within the inverter occur. This in turn increases the noise of the clock signal generated by the conventional oscillator circuit shown in Fig. 1. Further, a Schmitt trigger being a logical inverter implemented as a CMOS Schmitt trigger causes electrostatic discharge problems.

Accordingly, it is an object of the present invention to provide an oscillator circuit and a method for generating an oscillation signal which overcome the above-mentioned disadvantages and which generate an oscillation signal with a low technical complexity.

This object is achieved by an oscillator circuit comprising the features of claim 1.

An advantage of the oscillator circuit comprising the features of claim 1 is that the oscillator circuit can be implemented with a very low technical complexity but does still generate an oscillation signal very reliably.

A further advantage of the oscillator circuit according to the first aspect of the present invention relies in that there are no cross currents so that the noise of the generated oscillation signal is minimized.

A further advantage of the oscillator circuit according to the first aspect of the present invention is that it can be integrated in an integrated circuit IC and does occupy a very small area on the chip when integrated on said chip.

A further advantage of the oscillator circuit according to the first aspect of the present invention is that the power consumption of the oscillator circuit is very low.

In a possible embodiment of the oscillator circuit according to the present invention, the inverter of the oscillator circuit is implemented as a CMOS inverter.

In a further possible embodiment of the oscillator circuit according to the present invention, the switching element comprises PMOS transistors which switch in response to control signals generated by serial connected signal inverting elements.

In a further possible embodiment of the oscillator circuit according to the present invention, the level shift element comprises a voltage source.

In a further possible embodiment of the oscillator circuit according to the present invention, the level shift element comprises a resistor.

In a further possible embodiment of the oscillator circuit according to the present invention, the level shift element comprises a diode connected MOS transistor.

In a further possible embodiment of the oscillator circuit according to the present invention, the level shift element comprises a pn junction diode.

In a further possible embodiment of the oscillator circuit according to the present invention, the level shift element comprises a source follower.

In a further possible embodiment of the oscillator circuit according to the present invention, the level shift element comprises a Zenner diode.

In a further possible embodiment of the oscillator circuit according to the present invention, the level shift element comprises a serial connection of a voltage source and/or a resistor and/or a diode connected MOS transistor and/or a pn junction diode and/or a source follower and/or a Zenner diode.

In a still further possible embodiment of the oscillator circuit according to the present invention, the gate of the PMOS transistor and the gate of the NMOS transistor of said inverter are connected to the feedback element and a capacitor.

In a possible embodiment of the oscillator circuit according to the present invention, the feedback element is a feedback resistor.

In a further possible embodiment of the oscillator circuit according to the present invention, the oscillation frequency of the generated oscillation signal is given by:

$$f_{osc} = 1/T = 1/A{*}RC,$$

wherein RC is a time constant depending on the resistance of said feedback resistor and the capacity of said capacitor,
wherein A is a factor depending on the hysteresis of said inverter and having a value in a range from 0.8 to 2.5.

In a further possible embodiment of the oscillator circuit according to the present invention, by the potential applied to the bulk of the PMOS transistor and/or to the bulk of the NMOS transistor the threshold voltage of the respective transistor is shifted.

In a further possible embodiment of the oscillator circuit according to the present invention, the oscillation frequency of the oscillation signal is adjustable.

The invention further provides an integrated circuit having the features of claim 8.

According to this second aspect of the present invention, an integrated circuit comprising at least one oscillator circuit according to the first aspect of the present invention is provided.

The invention further provides a method having the features of claim 9.

In a possible embodiment of the method according to the present invention, the shifting of the potential applied to the bulk of the at least one MOS transistor within the inverter is performed by a level shift element wherein said level shift element comprises any combination of one of the following elements comprising a voltage source, a resistor, a diode connected MOS transistor, a pn junction diode, a source follower, a Zenner diode or a serial connection of any of the above listed entities.

In a possible embodiment of the method according to the present invention, the oscillation frequency of the generated oscillation signal is given by:

$$f_{osc} = 1/T = 1/A*RC,$$

wherein RC is a time constant depending on the resistance of the feedback resistor and the capacity of a capacitor and A is a factor depending on the hysteresis of the inverter and having a value in a range from 0.8 to 2.5.

In the following, possible embodiments of the oscillator circuit and the method for generating an oscillation signal are described in more detail with reference to the enclosed figures.

Fig. 1     shows a conventional oscillator circuit based on a Schmitt trigger;

Fig. 2     shows a possible implementation of an inverter within an oscillator circuit according to the first aspect of the present invention;

Fig. 3     shows a possible embodiment of an oscillator circuit according to the first aspect of the present invention;

Fig. 4     shows a diagram illustrating the operation of an oscillator circuit according to the first aspect of the present invention;

Figs. 5A to 5D     show signal diagrams illustrating the operation of an oscillator circuit according to the present invention.

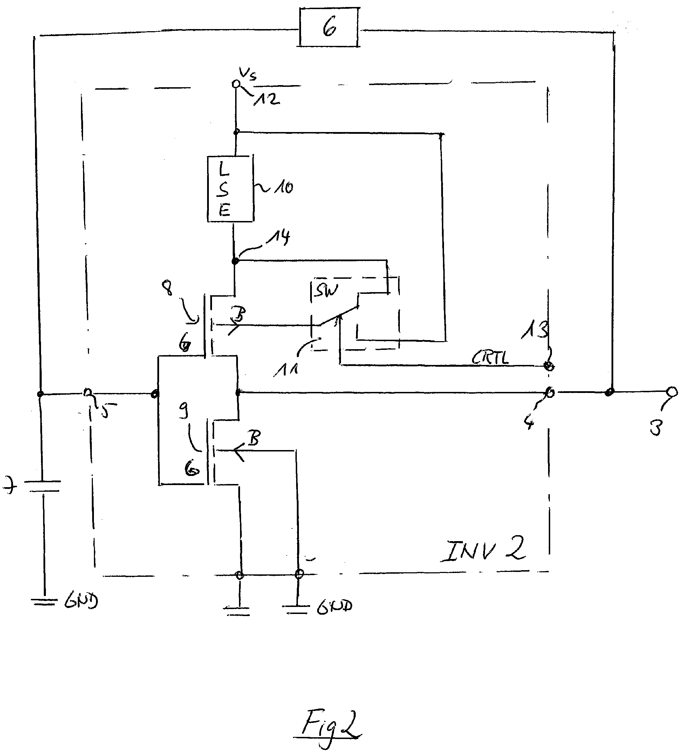

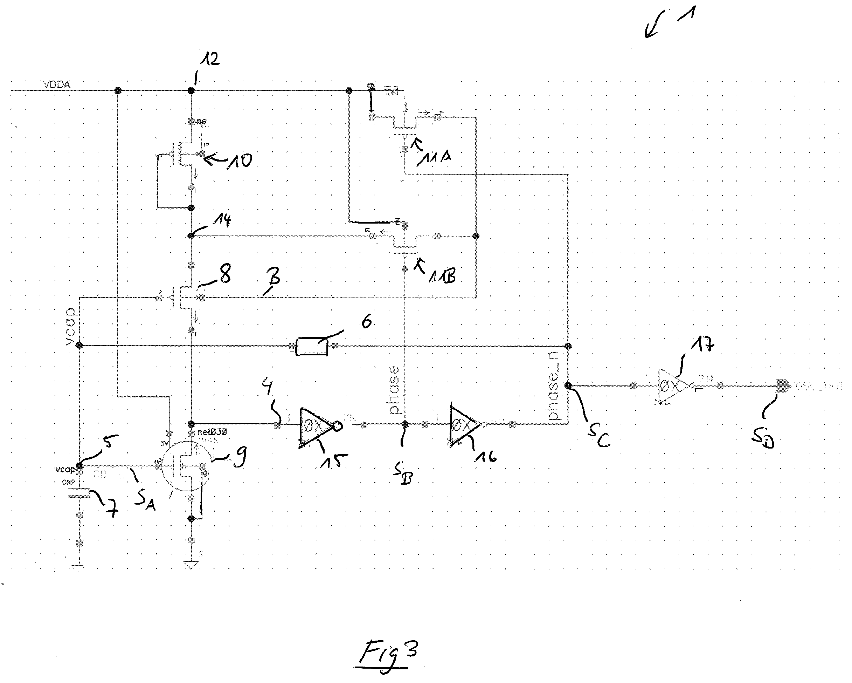

As can be seen in Fig. 2, an oscillator circuit 1 according to the first aspect of the present invention comprises in the shown embodiment at least one inverter 2. The oscillator circuit 1 comprises a signal output 3 to output an oscillation signal generated by the oscillator circuit 1. The inverter 2 within the oscillator circuit 1 has an output 4 connected to an input 5 of the inverter 2 via a feedback element 6. The feedback element 6 can be in a possible implementation formed by a resistor. In the shown embodiment of Fig. 2, further a capacitor 7 is connected between the input 5 of the inverter circuit 2 and ground potential (GND). The inverter 2 shows a hysteresis. The inverter 2 comprises a PMOS transistor 8 and a NMOS transistor 9. The gate terminals G of the PMOS transistor 8 and of the NMOS transistor 9 are both connected to the input 5 of the inverter 2 as illustrated in Fig. 2. In the embodiment shown in Fig. 2 the potential applied to the bulk B of the PMOS transistor 8 can be shifted by a level shift element 10 to provide the hysteresis of the inverter 2. As can be seen in Fig. 2 the bulk B of the PMOS transistor 8 is connected to a switching element 11 which can be implemented by at least one MOS transistor. The electrical potential applied to the bulk B of the PMOS transistor 8 is switched by means of the switching element 11 between a supply voltage $V_S$ applied to the inverter 2 via the supply voltage terminal 12 and a shifted voltage provided by the level shift element 10. The switching element 11 is controlled by a threshold controlled signal CTRL applied to a control input 13 of the inverter circuit 2. The control signal can be generated by an external control circuit (not shown in Fig. 2) or derived from the output signal of the inverter 2 as illustrated in the embodiment shown in Fig. 3. In the embodiment shown in Fig. 2, the potential applied to the bulk B of the PMOS transistor 8 is shifted by a level shift element 10 to provide the hysteresis of the inverter 2. In an alternative embodiment, the potential applied to the bulk B of the NMOS transistor 9 is shifted by a level shift element to provide the hysteresis of the inverter 2. In a still further possible embodiment, the potential applied to the bulk of the PMOS transistor 8 and to the bulk of the NMOS transistor 9 is shifted by two corresponding level shift elements to provide the hysteresis of the inverter 2.

In a possible embodiment, the inverter 2 can be implemented by a CMOS inverter. The level shift element 10 as shown in Fig. 2 can in a possible embodiment be formed by a voltage source. In a further alternative embodiment, the level shift element 10 can be formed by a resistor. In a further embodiment, the level shift element 10 can also be formed by a diode connected MOS transistor. In a still further possible embodiment, the level shift element 10 can be formed by a pn junction diode. In a further alternative embodiment, the level shift element 10 can be formed by a source follower. In a further possible embodiment, the level shift element 10 within the inverter 2 can be formed by a Zenner diode.

In a still further possible embodiment, the level shift element can be formed by a serial connection of several elements comprising any combination of a voltage source, a resistor, a diode connected MOS transistor, a pn junction diode, a source follower or a Zenner diode. In the embodiment shown in Fig. 2 the gate of the PMOS transistor 8 and the gate of the NMOS transistor 9 of the inverter 2 are connected to the feedback element 6 at the input 5 of the inverter 2 and to the capacitor 7. The feedback element 6 can be formed by a feedback resistor.

The oscillation frequency $f_{osc}$ of the generated oscillation signal output at the output terminal 3 of the oscillator circuit 1 is given by:

$$f_{OSC} = 1/T = 1/A*RC,$$

wherein RC is a time constant depending on the resistance R of the feedback resistor 6 and the capacity C of the capacitor 7 and wherein A is a factor depending on the hysteresis of the inverter 2. In a possible embodiment, the factor A can be in a range from 0.8 to 2.5. In a possible embodiment, the oscillation frequency $f_{osc}$ of the oscillation signal is adjustable. In a possible implementation, the resistance R of the resistor 6 forming the feedback element can be adjusted to change the oscillation frequency. In a further possible embodiment, the capacity C of the capacitor 7 can be changed to adjust the oscillation frequency of the oscillation signal.

In a possible embodiment, the inverter circuit 2 can be formed by an integrated circuit. In a possible embodiment, also the feedback element 6 and the capacitor 7 can be integrated in this integrated circuit IC. In an alternative embodiment, the feedback element 6 and the capacitor 7 can be formed by discrete elements not integrated in the inverter 2.

The oscillator circuit 1 according to the present invention comprises the inverter 2 with hysteresis, wherein the hysteresis is provided by a back-gate effect. The threshold voltage $V_T$ of a MOS transistor increases when its source-bulk voltage difference increases. When the bulk terminal B of an MOS transistor is connected to different voltages, the MOS transistor also obtains different threshold voltages $V_T$. In the embodiment shown in Fig. 2, the bulk terminal B of the PMOS transistor 8 is switched between different voltages, i.e. a supply voltage $V_S$ applied to the supply voltage terminal 12 and the shifted voltage provided by the level shift element 10 applied at node 14 as illustrated in Fig. 2.

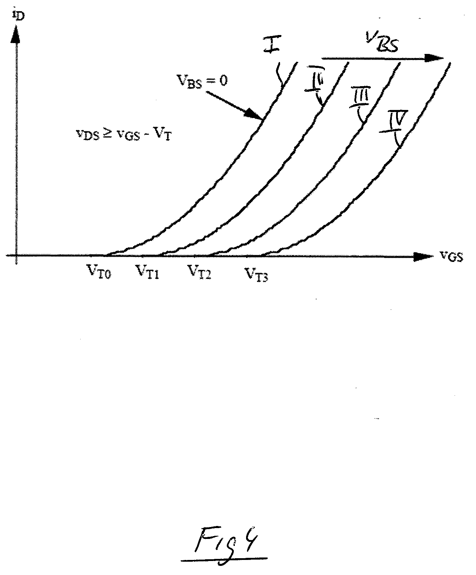

Fig. 4 shows a diagram for illustrating the bulk-source influence on the transconductance characteristics of a MOS transistor. As can be seen in Fig. 4, when increasing the bulk-source voltage between the bulk terminal B of the transistor and the source terminal S of the respective transistor, the threshold voltage $V_T$ is increased as well. In the diagram shown in Fig. 2 the switching element 11 is switched to a position where the bulk terminal B of the PMOS transistor 8 is directly connected to the source terminal of the PMOS transistor 8 at node 14. Accordingly, in this position the bulk-source voltage $V_{BS}$ is 0 according to the first curve I of the diagram of Fig. 4. With changing values of the bulk-source voltage $V_{BS}$ the threshold voltage $V_T$ of the respective MOS transistor changes as illustrated in Fig. 4 as curves II, III, IV. In turn, the change in the threshold voltage $V_T$ causes also a change in the switching threshold voltage at which the inverter 2 changes its output state. In the embodiment shown in Fig. 2 using the control signal CTRL, the bulk B of the PMOS transistor 8 is switched either to the supply potential $V_S$ or to the potential shifted downwards by the level shift element 10. This voltage shift can be performed by different types or combinations of entities comprising inter alia a voltage source, a resistor, a diode connected MOS transistor, a pn junction diode, a source follower or a Zenner diode. Instead of level shifting, also other lower supply voltages can be used if available on the respective chip.

Fig. 3 shows a possible implementation of an oscillator circuit 1 according to the present invention. In the shown implementation, the switching element 11 comprises PMOS transistors 11a, 11b which switch in response to control signals generated by serial connected signal inverting elements 15, 16 and connected to a common junction node 4 of the PMOS transistor 8 and the NMOS transistor 9 of the inverter 2.

The output signal of the first inverting element 15 is applied as a control signal to the gate G of the switching PMOS transistor 11b and the output signal of the second inverting element 16 is applied as a control signal to the gate G of the switching PMOS transistor 11a as illustrated in Fig. 3. The control signals output by the inverting elements 15, 16 form complementary control signals applied to the gates of the switching PMOS transistors 11a, 11b. When the first PMOS switching transistor 11a is switched on, the bulk B of the PMOS transistor 8 of the inverter 2 is connected to the positive supply voltage $V_S$ at the node 12 as illustrated in Fig. 3. When the first switching PMOS transistor 11a is switched on, the second PMOS transistor 11b is switched off and vice versa. When the second PMOS switching transistor 11b is switched on, the bulk terminal B of the PMOS transistor 8 of the inverter 2 is connected to the node 14 having the shifted electrical potential provided by the level shift element 10 as illustrated in Fig. 3. In the embodiment shown in Fig. 3, control signals for the PMOS switching transistors 11a, 11b forming the switching element 11 are generated by means of serial connected inverting elements 15, 16 connected to the output terminal 4 of the inverter 2. In the shown embodiment of Fig. 3 no external control signals must be applied to the integrated switching PMOS transistors 11a, 11b because the control signals are derived directly from the output signal of the integrated inverter stage 2 comprising the PMOS transistor 8 and the NMOS transistor 9. In the embodiment shown in Fig. 3, the feedback element 6 is formed by a resistor having for instance a resistance of 20kΩ. The capacitor 7 can have a capacitance C of 1pF. In the shown embodiment of Fig. 3, a further inverter element 17 can be provided for inverting the generated output oscillation signal.

All elements shown in Fig. 3 can be integrated on a single chip in a possible implementation.

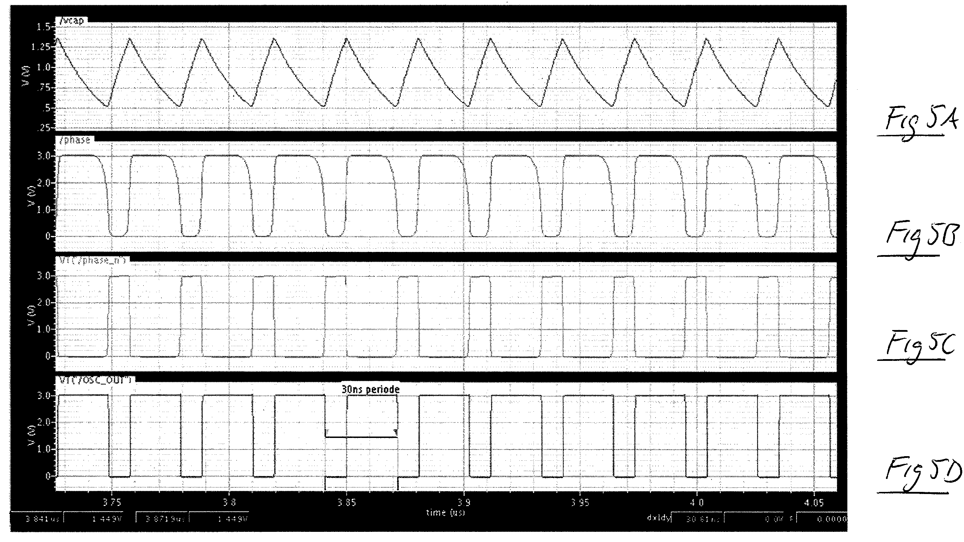

Figs. 5A, 5B, 5C, 5D show signals $S_A$, $S_B$, $S_C$, $S_D$ as illustrated in Fig. 3. As can be seen in Fig. 5 in the shown exemplary embodiment, the current time constant RC gives a 30ns clock period of the rectangular shaped output oscillation signal $S_D$ shown in Fig. 5D. In a possible embodiment, the oscillation frequency of the generated oscillation output signal $S_D$ is given by:

$$f_{osc} = 1/T = 1/A*RC,$$

wherein RC is the time constant depending on the resistance R of the feedback resistor 6 and the capacity C of the capacitor 7, and wherein A is a factor depending on the hysteresis of the inverter and the factor A can range between 0.8 and 2.5 in a possible embodiment.

In a further possible embodiment of the oscillator circuit 1 not only the bulk B of the PMOS transistor 8 is switched between different potentials but also the bulk B of the NMOS transistor 9. Accordingly, in a possible embodiment, there is not only a bulk control of the PMOS transistor 8 but also a bulk control of the NMOS transistor 9. In this way, the hysteresis of the inverter 2 can be made symmetrical. Further, the back-gate effect will provide a higher total hysteresis of the inverter 2 and a lower oscillation frequency.

The oscillator circuit 1 as illustrated for example in the implementation shown in Fig. 3 comprises low technical complexity and can be simply realized by standard elements. All these elements can be integrated on a single chip. The oscillator circuit 1 operates without any cross current losses so that no constant DC current is flowing during operation. Consequently, the power consumption of the oscillator circuit 1 according to the first aspect of the present invention is very low. The oscillator circuit 1 as illustrated in Fig. 3 does occupy only a very small area when integrated on a chip. Since no cross current peaks occur, the noise of the generated clock signal output by the oscillator circuit 1 is very low. The oscillator circuit 1 as illustrated in Fig. 3 can be used to generate oscillation signals in a wide range of oscillation frequencies. This range of oscillation frequency can be from several hertz to several gigahertz.

## Claims

1. An oscillator circuit (1) adapted to generate an oscillation signal comprising at least one inverter (2) with hysteresis having an output (4) connected to an input (5) of the inverter (2) via a feedback element (6), wherein said inverter (2) comprises a PMOS transistor (8) and a NMOS transistor (9),
where the potential applied to the bulk (B) of said PMOS transistor (8) or to the bulk (B) of said NMOS transistor (9) is shifted by a level shift element (10) to provide the hysteresis of said inverter (2);
wherein the potential applied to the bulk (B) of said PMOS transistor (8) or to the bulk (B) of said NMOS transistor (9) is switched by means of a switching element (11) between a supply voltage and a shifted voltage provided by said level shift element (10),
**characterized in that**
said switching element (11) comprises PMOS transistors (11A, 11B) which switch in response to control signals generated by serial connected signal inverting elements (15, 16) being connected to a common junction node (4) of said PMOS transistor (8) and said NMOS transistor (9) of said inverter (2).
wherein said level shift element (10) comprises

> a voltage source, or
> a resistor, or
> a diode connected MOS transistor, or
> a pn junction diode, or
> a source follower, or
> a Zener diode; or
> a serial connection of some of the above listed devices.

2. The oscillator circuit according to claim 1, wherein said inverter (2) is a CMOS inverter.

3. The oscillator circuit according to one of the preceding claims 1 to 3, wherein the gate of the PMOS transistor (8) and the gate of the NMOS transistor (9) of said inverter (2) are connected to an input (5) of said inverter (2) being connected to the feedback element (6) and to a capacitor (7) connected between the input (5) of the inverter (2) and ground potential (GND).

4. The oscillation circuit according to one of the preceding claims 1 to 3, wherein the feedback element (6) is a feedback resistor.

5. The oscillator circuit according to claim 4, wherein the oscillation frequency of the generated oscillation signal is given by:

$$f_{osc} = 1/T = 1/A*RC,$$

wherein RC is a time constant depending on the resistance R of said feedback resistor and the capacity C of said capacitor,

wherein A is a factor depending on the hysteresis of said inverter (2) and having a value in a range from 0.8 to 2.5.

6. The oscillator circuit according to one of the preceding claims 1 to 5, wherein by the potential applied to the bulk (B) of the PMOS transistor (8) or to the bulk (B) of said NMOS transistor (9) the threshold voltage ($V_T$) of the respective transistor is shifted.

7. The oscillator circuit according to claim 5, wherein the oscillation frequency ($f_{osc}$) of said oscillation signal is adjustable by means of an adjustable feedback resistor (6) or an adjustable capacitor (7).

8. An integrated circuit comprising at least one oscillator circuit (1) according to one of the preceding claims 1 to 7.

9. A method for generating an oscillation signal by means of an inverter (2) with a hysteresis whose output is feedback to its input,

where the hysteresis of said inverter (2) is provided by shifting a potential applied to a bulk (B) of at least one MOS transistor (8; 9) within said inverter (2),

wherein the potential applied to the bulk (B) of the at least one MOS transistor (8; 9) is switched by means of a switching element (11) between a supply voltage and a shifted voltage provided by a level shift element (10),

**characterized in that**

said switching element (11) comprises PMOS transistors (11A, 11B) which switch in response to control signals generated by serial connected signal inverting elements (15, 16) being connected to a common junction node (4) of said PMOS transistor (8) and said NMOS transistor (9) of said inverter (2), wherein said level shift element (10) comprises:

    a voltage source, or
    a resistor, or
    a diode connected MOS transistor, or
    a pn junction diode, or
    a source follower, or
    a Zener diode, or
    a serial connection of some of the above listed devices.

**Patentansprüche**

1. Oszillatorkreis (1), der dafür eingerichtet ist, ein Oszillationssignal zu erzeugen, der mindestens einen Inverter (2) mit Hysterese umfasst und einen Ausgang (4) aufweist, der mit einem Eingang (5) des Inverters (2) über ein Rückmeldungselement (6) verbunden ist, wobei der Inverter (2) einen PMOS-Transistor (8) und einen NMOS-Transistor (9) umfasst, wobei das Potenzial, das an das Volumen (B) des PMOS-Transistors (8) oder an das Volumen (B) des NMOS-Transistors (9) angelegt wird, durch ein Pegelverschiebungselement (10) verschoben wird, um die Hysterese des Inverters (2) bereitzustellen;

wobei das Potenzial, das an das Volumen (B) des PMOS-Transistors (8) oder an das Volumen (B) des NMOS-Transistors (9) angelegt wird, mittels eines Schaltelements (11) zwischen einer Versorgungsspannung und einer verschobenen Spannung, die durch das Pegelverschiebungselement (10) bereitgestellt wird, umgeschaltet wird,

**dadurch gekennzeichnet, dass**

das Schaltelement (11) PMOS-Transistoren (11A, 11B) umfasst, die in Reaktion auf Steuersignale schalten, die durch in Reihe geschaltete Signalinvertierungselemente (15, 16) erzeugt werden, die mit einem gemeinsamen Verbindungsknoten (4) des PMOS-Transistors (8) und des NMOS-Transistors (9) des Inverters (2) verbunden sind. wobei das Pegelverschiebungselement (10) Folgendes umfasst:

    eine Spannungsquelle oder
    einen Widerstand oder
    einen über eine Diode verbundenen MOS-Transistor oder
    eine pn-Übergangs-Diode oder
    einen Quellenfolger oder
    eine Zener-Diode oder
    eine Reihenschaltung einiger der oben genannten Vorrichtungen.

2. Oszillatorkreis nach Anspruch 1, wobei der Inverter (2) ein CMOS-Inverter ist.

3. Oszillatorkreis nach einem der vorangehenden Ansprüche 1. bis 3, wobei das Gate des PMOS-Transistors (8) und das Gate des NMOS-Transistors (9) des Inverters (2) mit einem Eingang (5) des Inverters (2) verbunden sind, der mit dem Rückmeldungselement (6) verbunden ist, und mit einem Kondensator (7) verbunden sind, der zwischen dem Eingang (5) des Inverters (2) und einem Erdungspotenzial (GND) verbunden ist.

4. Oszillatorkreis nach einem der vorangehenden Ansprüche 1 bis 3, wobei das Rückmeldungselement (6) ein Rückmeldungswiderstand ist.

5. Oszillatorkreis nach Anspruch 4, wobei die Oszillationsfrequenz des erzeugten Oszillationssignals gegeben ist durch:

$$f_{osc} = 1/T = 1/A*RC,$$

wobei RC eine Zeitkonstante ist, die vom Widerstandswert R des Rückmeldungswiderstands und von der Kapazität C des Kondensators abhängig ist, wobei A ein Faktor ist, der von der Hysterese des Inverters (2) abhängig ist und der einen Wert in einem Bereich von 0,8 bis 2,5 hat.

6. Oszillatorkreis nach einem der vorangehenden Ansprüche 1 bis 5, wobei durch das Potenzial, das an das Volumen (B) des PMOS-Transistors (8) oder an das Volumen (B) des NMOS-Transistors (9) angelegt wird, die Schwellenspannung ($V_T$) des jeweiligen Transistors verschoben wird.

7. Oszillatorkreis nach Anspruch 5, wobei die Oszillationsfrequenz ($f_{osc}$) des Oszillationssignals mittels eines einstellbaren Rückmeldungswiderstands (6) oder eines einstellbaren Kondensators (7) einstellbar ist.

8. Integrierter Schaltkreis, der mindestens einen Oszillatorkreis (1) nach einem der vorangehenden Ansprüche 1 bis 7 umfasst.

9. Verfahren zum Generieren eines Oszillationssignals mittels eines Inverters (2) mit einer Hysterese, dessen Ausgangssignal zu seinem Eingang zurückgemeldet wird,
wobei die Hysterese des Inverters (2) durch Verschieben eines Potenzials bereitgestellt wird, das an ein Volumen (B) mindestens eines MOS-Transistors (8; 9) innerhalb des Inverters (2) angelegt wird,
wobei das Potenzial, das an das Volumen (B) des mindestens einen MOS-Transistors (8; 9) angelegt wird, mittels eines Schaltelements (11) zwischen einer Versorgungsspannung und einer verschobenen Spannung, die durch ein Pegelverschiebungselement (10) bereitgestellt wird, geschaltet wird,
**dadurch gekennzeichnet, dass**
das Schaltelement (11) PMOS-Transistoren (11A, 11B) umfasst, die in Reaktion auf Steuersignale schalten, die durch in Reihe geschaltete Signalinvertierungselemente (15, 16) erzeugt werden, die mit einem gemeinsamen Verbindungsknoten (4) des PMOS-Transistors (8) und des NMOS-Transistors (9) des Inverters (2) verbunden sind,
wobei das Pegelverschiebungselement (10) Folgendes umfasst:

eine Spannungsquelle oder
einen Widerstand oder
einen über eine Diode verbundenen MOS-Transistor oder
eine pn-Übergangs-Diode oder

einen Quellenfolger oder
eine Zener-Diode oder
eine Reihenschaltung einiger der oben genannten Vorrichtungen.

**Revendications**

1. Circuit d'oscillation (1) adapté pour générer un signal d'oscillation comprenant au moins un inverseur (2) avec une hystérésis ayant une sortie (4) reliée à une entrée (5) de l'inverseur (2) par l'intermédiaire d'un élément de rétroaction (6), dans lequel ledit inverseur (2) comprend un transistor PMOS (8) et un transistor NMOS (9), où le potentiel appliqué à la masse (B) dudit transistor PMOS (8) ou à la masse (B) dudit transistor NMOS (9) est décalé par un élément de décalage de niveau (10) pour fournir l'hystérésis dudit inverseur (2);
dans lequel le potentiel appliqué à la masse (B) dudit transistor PMOS (8) ou à la masse (B) dudit transistor NMOS (9) est commuté au moyen d'un élément de commutation (11) entre une tension d'alimentation et une tension décalée fournie par ledit élément de décalage de niveau (10),
**caractérisé en ce que** ledit élément de commutation (11) comprend des transistors PMOS (11a, 11b) qui commutent en réponse à des signaux de commande générés par des éléments d'inversion de signal connectés en série (15, 16) qui sont connectés à un noeud de jonction commun (4) dudit transistor PMOS (8) et dudit transistor NMOS (9) dudit inverseur (2),
dans lequel ledit élément de décalage de niveau (10) comprend :

une source de tension, ou
une résistance, ou
un transistor MOS connecté à une diode, ou
une diode à jonction pn, ou
un suiveur de source, ou
une diode Zener, ou
une connexion en série de certains des dispositifs mentionnés ci-dessus.

2. Circuit d'oscillation selon la revendication 1, dans lequel ledit inverseur (2) est un inverseur CMOS.

3. Circuit d'oscillation selon l'une quelconque des revendications précédentes 1 à 3, dans lequel la grille du transistor PMOS (8) et la grille du transistor NMOS (9) dudit inverseur (2) sont reliées à une entrée (5) dudit inverseur (2) qui est reliée à l'élément de rétroaction (6) et à un condensateur (7) connecté entre l'entrée (5) de l'inverseur (2) et le potentiel de masse (GND).

4. Circuit d'oscillation selon l'une quelconque des revendications précédentes 1 à 3, dans lequel l'élément de rétroaction (6) est une résistance de rétroaction.

5. Circuit d'oscillation selon la revendication 4, dans lequel la fréquence d'oscillation du signal d'oscillation généré est donnée par :

$$f_{osc} = 1/T = 1/A*RC,$$

où RC est une constante de temps dépendant de la résistance R de ladite résistance de rétroaction et de la capacité C dudit condensateur,
où A est un facteur dépendant de l'hystérésis dudit inverseur (2) et ayant une valeur comprise dans une plage de 0,8 à 2,5.

6. Circuit d'oscillation selon l'une quelconque des revendications précédentes 1 à 5, dans lequel, par le potentiel appliqué à la masse (B) du transistor PMOS (8) ou à la masse (B) dudit transistor NMOS (9), la tension de seuil ($V_T$) du transistor respectif est décalée.

7. Circuit d'oscillation selon la revendication 5, dans lequel la fréquence d'oscillation ($F_{osc}$) dudit signal d'oscillation est réglable au moyen d'une résistance de rétroaction réglable (6) ou d'un condensateur réglable (7).

8. Circuit intégré comprenant au moins un circuit d'oscillation (1) selon l'une des revendications précédentes 1 à 7.

9. Procédé pour générer un signal d'oscillation au moyen d'un inverseur (2) avec une hystérésis dont la sortie est réinjectée à son entrée, où l'hystérésis dudit inverseur (2) est fournie en décalant un potentiel appliqué à une masse (B) d'au moins un transistor MOS (8 ; 9) au sein dudit inverseur (2),
dans lequel le potentiel appliqué à la masse (B) dudit au moins un transistor MOS (8, 9) est commuté au moyen d'un élément de commutation (11) entre une tension d'alimentation et une tension décalée fournie par un élément de décalage de niveau (10),
**caractérisé en ce que** ledit élément de commutation (11) comprend des transistors PMOS (11a, 11b) qui commutent en réponse à des signaux de commande générés par des éléments d'inversion de signal connectés en série (15, 16) qui sont connectés à un noeud de jonction commun (4) dudit transistor PMOS (8) et dudit transistor NMOS (9) dudit inverseur (2),
dans lequel ledit élément de décalage de niveau (10) comprend :

une source de tension, ou
une résistance, ou
un transistor MOS connecté à une diode, ou
une diode à jonction pn, ou
un suiveur de source, ou
une diode Zener, ou
une connexion en série de certains des dispositifs mentionnés ci-dessus.

Square Wave Oscillator

Fig 1

Fig 2

Fig 3

$v_{DS} \geq v_{GS} - V_T$

Fig 4

EP 2 779 450 B1

Fig 5A

Fig 5B

Fig 5C

Fig 5D

EP 2 779 450 B1

13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 200408844 A1

**Non-patent literature cited in the description**

- *CMOS Schmitt Trigger, A Uniquely Versatile Design Component,* 31 December 1998